# EUROPÄISCHE PATENTSCHRIFT

(11) **EP 0 657 092 B1**
(45) Veröffentlichungstag und Bekanntmachung des Hinweises auf die Patenterteilung: **19.06.1996**
(21) Anmeldenummer: 93918906.4
(22) Anmeldetag: 20.08.1993
(51) Int. Cl.: H05K 13/04

(54) **FIXIERHILFE ZUM VERBINDEN VON BAUTEILGURTEN**
SPLICING AID FOR JOINING COMPONENT-CARRYING BELTS
AUXILIAIRE DE FIXATION POUR RELIER DES BANDES-SUPPORTS POUR COMPOSANTS

(30) Priorität: 25.08.1992 DE 9211415 U
(43) Veröffentlichungstag der Anmeldung: 14.06.1995
(73) Patentinhaber: SIEMENS AKTIENGESELLSCHAFT, D-80333 München (DE)
(72) Erfinder: SCHULZE-KAHLEYSS, Rainer, D-91341 Röttenbach (DE); HIERL, Robert, D-92272 Freudenberg (DE)
(86) Internationale Anmeldenummer: DE9300764
(87) Internationale Veröffentlichungsnummer: WO9405143

(56) Entgegenhaltungen:
- CH-A- 676 703
- DE-A- 3 311 634

## Beschreibung

Die Erfindung bezieht sich auf eine Fixierhilfe zum Verbinden von Bauteilgurten, insbesondere von Gurten mit elektronischen SMD-Bauelementen zum Zuführen der Bauelemente zu Bestückautomaten od. dgl., wobei die Gurte in einer seitlichen Spur Führungslöcher im Raster aufweisen.

Die Bestückung von Leiterplatten mit Bauteilen, insbesondere mit elektronischen SMD-Bauelementen, erfolgt in zeitgemäßer Technik üblicherweise mit Bestückautomaten nach dem sogenannten "PICK-AND-PLACE"-Prinzip. Zur Gewährleistung einer hohen Bestückgeschwindigkeit werden dabei die Bauteile in Gurten, beispielsweise mit sog. Kunststoff-Blistern oder auch in stabilen Pappstreifen mit Ausnehmungen, konfektioniert und dem Bestückkopf zugeführt. Mit solchen Gurten kann die Maschine weitgehend ohne Stillstand betrieben werden. Allerdings treten dabei am Gurtende Probleme dann auf, wenn das Ende eines ersten Gurtes mit dem Anfang eines zweiten Gurtes verbunden werden muß, was als sogenanntes "Splicen" bezeichnet wird.

Für letzteren Zweck sind bereits Hilfsvorrichtungen vorgeschlagen worden, bei denen ein Gurtende und ein Gurtanfang mit seinen Führungslöchern in Dornen fixiert werden und mittels Klebestreifen, von denen ein erster Streifen unterhalb und ein zweiter Streifen oberhalb der aneinanderstoßenden Gurtabschnitte gelegt wird, eine Fixierung erreicht wird. Derartige Klebestreifen sind z.B. als Spezialklebestreifen mit geteiltem Trägermaterial ausgebildet, von denen der Träger Führungslöcher im Rastermaß der Dorne der Hilfsvorrichtung aufweist.

Insgesamt ist die vorbekannte Vorrichtung vergleichsweise umständlich zu handhaben, so daß in der Praxis die Verbindung von Bauteilgurten häufig manuell ohne Hilfsvorrichtung erfolgt. Damit sind aber zwangsläufig Störungen wegen ungenauem Rastermaß, seitlich überstehendem Klebestreifen oder auch einem Verdrehen der Gurte verbunden.

Aufgabe der Erfindung ist es daher, eine Fixierhilfe zum Verbinden von Bauteilgurten zu schaffen, die ohne Verwendung zusätzlicher Hilfsvorrichtungen auskommt und ein praxisgerechtes Verbinden der Bauteilgurte ermöglicht.

Die Aufgabe ist erfindungsgemäß bei einer Fixierhilfe durch einen Träger mit wenigstens zwei parallelen Spuren gelöst, von denen die eine Spur Noppen im gleichen Raster wie die Führungslöcher des Gurtes und die weitere Spur einen lösbaren Klebestreifen aufweist. Vorzugsweise befinden sich die Noppen und der Klebestreifen auf der gleichen Flächenseite des Trägers. Der Träger besteht dabei auf einem für die Stanzung von Noppen geeigneten Material, insbesondere stärkerem Papier oder Kunststoff, und wird anschließend entfernt. Mit einer solchen Fixierhilfe ist bei der bestimmungsgemäßen Anwendung immer ein genaues Rastermaß und ein seitlich exakter Sitz des Klebestreifens gewährleistet.

Vorzugsweise können bei einer erfindungsgemäßen Fixierhilfe auch zwei Spuren mit Klebestreifen parallel auf dem Träger zur Anordnung auf beiden Seiten des Gurtes aufgebracht sein. Dabei ist zwischen beiden Spuren mit Klebestreifen ein Biegefalz oder eine Materialverdünnung im Träger vorhanden. Damit wird die Anwendung der Fixierhilfe weiter vereinfacht und ermöglicht so eine schnellere Verbindung von Gurtende und Gurtanfang. Dabei können auch auf beide den Klebestreifen außen benachbarten Spuren des Trägers Noppen im Raster wie die Führungslöcher des Gurtes vorhanden sein. Eine solche symmetrisch aufgebaute Fixierhilfe erleichtert weiter die bestimmungsgemäße Verwendung beim Gurtteilspleißen.

Die erfindungsgemäße Fixierhilfe ist vorteilhafterweise für solche Bauteilgurte verwendbar, die aus stabilem Papier oder Pappe mit Ausnehmungen bestehen, in denen die Bauteile eingebracht sind. Aber auch für Gurtmaterial aus Kunststoff und insbesondere auch breitere Gurte mit geprägten Taschen, d.h. sogenannten Blisterverpackungen, können beispielsweise nach Entfernung von zwei Bauteilen aus dem neuen Gurt beide Gurtenden Tasche in Tasche gedrückt werden und mit der erfindungsgemäßen Fixierhilfe beidseitig Klebestreifen ohne Herumbiegen des Trägers aufgebracht werden.

Besonders vorteilhaft ist bei der Erfindung, daß nunmehr auf mechanische Hilfsvorrichtungen gänzlich verzichtet werden kann. Die erfindungsgemäße Fixierhilfe ist magazinierbar, beispielsweise in Rollen od. dgl., wobei handelsübliche Spender zum Ablängen einzelner Streifen verwendet werden können. Alternativ dazu können einzelne Fixierhilfen fertig auf Länge geschnitten sein und als Schüttware in Beuteln od. dgl. konfektioniert vertrieben werden.

Weitere Einzelheiten und Vorteile der Erfindung ergeben sich aus der nachfolgenden Figurenbeschreibung von Ausführungsbeispielen, in der insbesondere auch die Arbeitsabfolge unter bestimmungsgemäßer Verwendung der erfindungsgemäßen Fixierhilfe ausgeführt wird.

Es zeigen
- FIG 1: einen Ausschnitt aus einem Bauteilgurt,
- FIG 2: die neue Verbindungshilfe zur Anwendung auf beide Seiten des Bauteilgurtes,
- FIG 3: eine Verbindungshilfe, die beidseitig auf den Bauteilgurt aufbringbar ist und
- FIG 4: eine vergrößerte Schnittdarstellung längs der Linie IV-IV in FIG 3,
- FIG 5: eine Verbindungshilfe gemäß FIG 3, die symmetrisch aufgebaut ist,
- FIG 6: eine vergrößerte Schnittdarstellung längs der Linie VI-VI in FIG 5 und
- FIG 7: die bestimmungsgemäße Anwendung der Verbindungshilfe gemäß den FIG 5 und 6.

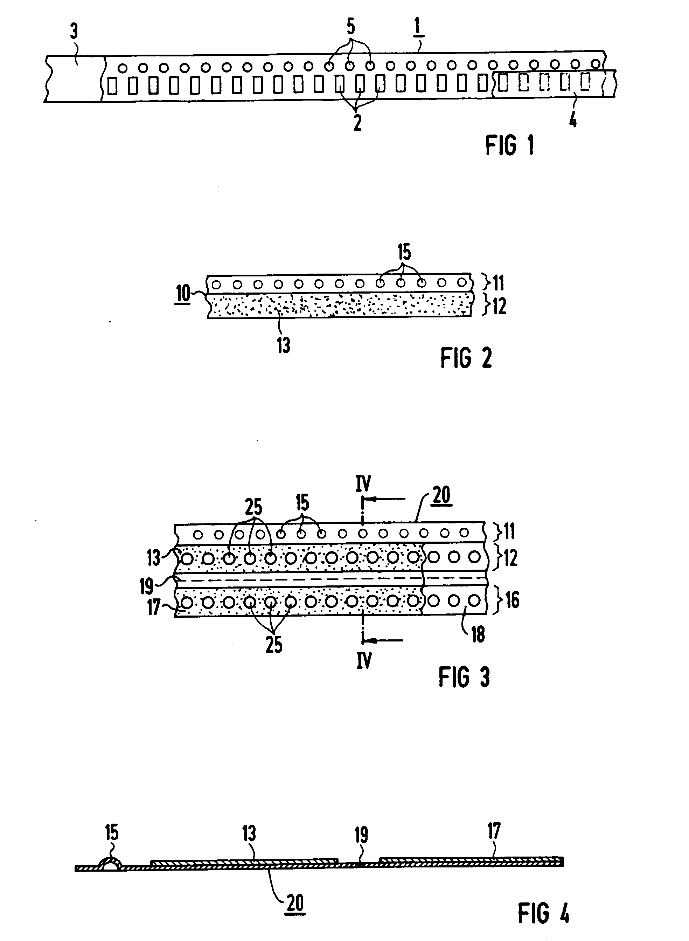

In FIG 1 kennzeichnet 1 einen Bauteilgurt zur Verwendung bei Bestückautomaten. Ein solcher Gurt 1 besteht beispielsweise aus stabilem Papier und weist hintereinander in Gurtrichtung einzelne Taschen 2 auf, in welche anschlußdrahtlose Bauelemente (SMD-Bauteile) eingebracht werden können. Dafür ist die Unterseite des Bauteilgurtes 1 mit einem dünnen Trägerpapier 3 kaschiert und die Oberseite nach Bestückung mit den Bauelementen mit einer üblicherweise transparenten Abzugsfolie 4 versehen.

Der so beschriebene Trägergurt 1 für SMD-Bauteile hat üblicherweise in einer Seitenspur Führungslöcher 5 im Rastermaß, die eine geeignete Transportsteuerung des Gurtes 1 ermöglichen. Bei Ablauf eines ersten Gurtes und Neuanfang eines zweiten Gurtes muß sichergestellt werden, daß das Ende des ersten Gurtes und der Anfang des zweiten Gurtes ohne Bauteillücke ineinander übergreifen. Hierzu sind vom Stand der Technik Hilfsvorrichtungen bekannt, bei denen die Gurtenden vorübergehend fixiert und beidseitig entsprechende Klebestreifen aufgebracht werden. Dazu sind jeweils Spezialklebestreifen mit geteiltem Trägermaterial notwendig, wobei die Handhabung insgesamt vergleichsweise kompliziert ist.

In FIG 2 ist zum Ersatz des Standes der Technik eine bandförmige Fixierhilfe dargestellt, die aus einem flexiblen Träger 10 besteht, der zwei parallele Spuren hat, und zwar eine erste Spur 11 und eine zweite Spur 12. Dabei sind in der ersten Spur im Rastermaß der Führungslöcher 5 des Bauteilgurtes 1 Noppen 15 eingebracht und in der zweiten Spur 12 ein abreißbarer Klebestreifen aufgebracht. Der abziehbare Klebestreifen 13 ist durch eine Klebefolie realisiert, die mit ihrer nichtklebenden Unterseite durch Ultraschall od. dgl. lösbar mit dem Träger verbunden ist. Die Klebeschicht befindet sich somit auf der Oberseite. Auf der Klebeschicht kann vor dem bestimmungsgemäßen Gebrauch eine Schutzfolie od. dgl. aufgebracht sein.

Zur Anwendung als Fixierhilfe greifen die Noppen 15 des Trägers exakt in die Löcher 5 des Gurtes 1. Durch die Noppen 15 in vorgegebenem Rastermaß ist es also möglich, auch bei manueller Handhabung der Gurtenden das vorgegebene Rastermaß einzuhalten. Eine spezielle Hilfsvorrichtung wird dann überflüssig. Nach dem Gebrauch als Fixierhilfe wird der Träger 10 abgezogen und weggeworfen.

In FIG 3 ist die Fixierhilfe gemäß FIG 2 mit einem Träger 20 so modifiziert, daß neben der Spur 12 mit Klebstreifen 13 eine weitere Spur 16 mit Klebstreifen 17 vorhanden ist. Dabei sind die Spuren 12 und 16 durch einen freien Teil des Trägers 20 getrennt, in dem ein Biegefalz 19 oder eine andere Materialverdünnung, wie Perforierung od. dgl., eingebracht ist. Letzteres wird insbesondere durch die Schnittdarstellung gemäß FIG 4 deutlich.

Auch die Klebestreifen 13 und 17 können Löcher 25 im Rastermaß aufweisen. Dies ist dann sinnvoll, wenn bei der bestimmungsgemäßen Anwendung von Bestückautomaten sogenannte Bauteilausstoßer verwendet werden, die einen Durchgriff durch Klebeteile od. dgl. benötigen.

Die erfindungsgemäßen Fixierhilfen werden als Endlosband auf einer Rolle od. dgl. magaziniert, wobei übliche Ablänggeräte für Folienstreifen zur Anwendung kommen.

Für Fixierhilfen gemäß FIG 2 und/oder FIG 3/4 ist nachfolgende Arbeitsfolge möglich: Zunächst werden die Enden zweier zu verbindender Bauteilgurte jeweils in Lochmitte durchgeschnitten. Anschließend wird ein Fixierklebestreifen vom handelsüblichen Spender in einer Länge von etwa 40 mm abgezogen und entnommen. Die Noppen des Fixierklebestreifens werden in die Gurtlöcher gedrückt, wodurch Anfang und Ende zweier Gurte sowohl im Raster als auch in der Lage genau fixiert sind. Der Klebestreifen wird auf der ersten Seite angedrückt. Dann wird bei einer Fixierhilfe gemäß FIG 2 das Trägermaterial abgezogen und auf der Rückseite des Gurtes der gleiche Vorgang ausgeführt. Bei einer Fixierhilfe gemäß FIG 3/4 wird der Träger 10 um den Gurt herumgebogen und der zweite Klebstreifen 17 auf der Gurtrückseite angedrückt. Nunmehr erfolgt in entsprechender Weise ein Abziehen des Trägermaterials. Die Gurtenden sind damit in kürzester Weise ohne eine notwendige Hilfsvorrichtung raster- und lagegenau verbunden.

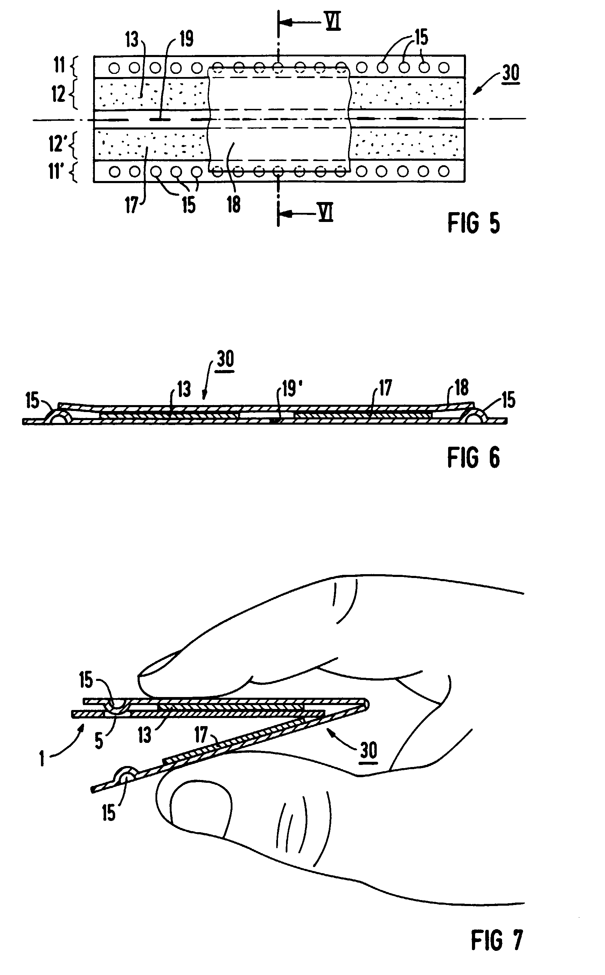

In FIG 5 ist ein fertiggeschnittener Träger 30 vorhanden, der beispielsweise die Länge von 4 bis 5 cm hat. Der Träger 30 ist in diesem Fall symmetrisch aufgebaut und hat ausgehend von der Symmetrielinie entsprechend einem Perforationsschnitt 19' jeweils zwei äußere Spuren 11 und 12 bzw. 11' und 12'. Auf den inneren Spuren 12 bzw. 12' befindet sich je ein Klebestreifen 13 und 17 entsprechend FIG 3, während jeweils auf den äußeren Spuren 11 bzw. 11' ein identisches Raster von Noppen 15 angeordnet ist. Die fertiggeschnittenen Verbindungshilfen sind auf der Oberseite jeweils mit einer Schutzfolie 18 abgedeckt, die vorteilhafterweise bis zu den Noppen reichen kann, wodurch das Abziehen unmittelbar vor der bestimmungsgemäßen Anwendung der Fixierhilfe vereinfacht wird.

Speziell der Schichtaufbau mit der Trägerschicht 30, den beiden Klebestreifen 13 und 17 und der Schutzfolie 18 ist in FIG 6 im einzelnen ersichtlich. Es hat sich als geeignet erwiesen, die Klebestreifen 13 und 17 auf ihren Unterseiten mit einem leichten Klebefilm mit geringerer Klebehaftung als auf der Oberseite der Klebestreifen zu versehen. Statt der konkreten Materialverdünnung 19 in FIG 3 kann der gleiche Zweck durch eine Vorstanzung 19' erreicht werden.

Insbesondere die Ausbildung der Verbindungshilfe gemäß den Figuren 5/6 ist aufgrund des symmetrischen Aufbaus richtungsunabhängig anwendbar und insbesondere bei SMD-Bauteilgurten einsetzbar. Die für eine solche Anwendung unabhängig von Typ und Hersteller der Bestückautomaten einsetzbaren Verbindungshilfen, die global als "SMD Double Splice Tape" bezeichnet werden können, werden zweckmäßigerweise als Schüttware im Beutel, beispielsweise zu 100 oder 500 Stück, geliefert und stehen somit konfektioniert als Vorrat beim laufenden Betrieb der Bestückautomaten zur Verfügung.

Die bestimmungsgemäße Anwendung speziell der Verbindungshilfe gemäß FIG 5 und 6 ist im einzelnen aus der FIG 7 ersichtlich. Insbesondere wird daraus deutlich, daß das Eindrücken der Noppen 15 in die Führungslöcher 5 von zu verbindenden Gurtenden und anschließend das Festdrücken des ersten Klebestreifens 13 leicht mit einer Hand erfolgen kann. Nach dem Umklappen des Trägers 30 entlang der Falzlinie 19 erfolgt von der Unterseite des Gurtes 1 her der sinngemäß gleiche Vorgang. Durch den Gegendruck der unteren Noppen 15 in die Führungslöcher 5 kann sich der obere Trägerteil mit den Noppen 15 aus den Führungslöchern herausbewegen und gleichermaßen wegen der nur geringen Klebehaftung vom Klebestreifen 13 lösen. Nach dem Andrücken des unteren Klebestreifens 17 wird mittels des freien oberen Trägerteils der gesamte Träger 30 abgezogen.

Auch bei Gurtmaterial aus Kunststoff und/oder breiten Gurten können die beschriebenen Fixierhilfen zur Anwendung kommen. Sofern als Blister geprägte Taschen vorhanden sind, werden nach Entfernung von jeweils zwei Bauteilen aus dem neuen Gurt beide Gurtenden Tasche in Tasche gedrückt. Anschließend wird beidseitig ein Klebestreifen gemäß FIG 2 aufgebracht, womit eine stabile Fixierung beider Gurte erreicht ist.

## Patentansprüche

1. Fixierhilfe zum Verbinden von Bauteilgurten, insbesondere mit elektronischen SMD-Bauelementen zum Zuführen der Bauelemente zu Bestückautomaten, wobei die Gurte in einer seitlichen Spur Führungslöcher im Raster aufweisen, **gekennzeichnet** durch einen Träger (10, 20, 30) mit wenigstens zwei parallelen Spuren (11; 12, 16), von denen die eine Spur (11) Noppen (15) im gleichen Raster wie die Führungslöcher (5) des Gurtes (1) und die weitere Spur (12, 16) wenigstens einen lösbaren Klebestreifen (13, 17) aufweist.

2. Verbindungshilfe nach Anspruch 1, **dadurch gekennzeichnet**, daß sich die Noppen (15) und der Klebestreifen (13, 17) auf der gleichen Flächenseite des Trägers (10, 20, 30) befinden.

3. Fxierhilfe nach Anspruch 2, **dadurch gekennzeichnet**, daß je zwei Spuren (12, 16) mit Klebestreifen (13, 17) parallel auf dem Träger (20, 30) zur Anordnung auf beiden Seiten des Gurtes (1) aufgebracht sind und zwischen beiden Spuren (12, 16) eine Materialverdünnung im Träger (20, 30) vorhanden ist.

4. Fxierhilfe nach Anspruch 3, **dadurch gekennzeichnet**, daß zwischen beiden Spuren (12, 16) mit Klebestreifen (13, 17) ein Biegefalz (19) im Träger (20, 30) vorhanden ist, wobei durch Umknicken des Trägers (10) der zweite Klebestreifen (17) gleichzeitig auf der Unterseite des Gurtes (1) lage- und rastergenau aufbringbar ist.

5. Verbindungshilfe nach Anspruch 3 oder Anspruch 4, **dadurch gekennzeichnet**, daß auf beiden den Klebestreifen (17, 18) außen benachbarten Spuren (12, 12') des Trägers (30) Noppen (15) im Raster wie die Führungslöcher (5) des Gurtes (1) vorhanden sind.

6. Fxierhilfe nach Anspruch 1 oder Anspruch 3, **dadurch gekennzeichnet**, daß die äußere Schicht des/der Klebestreifens/en (13, 17) durch eine vor der bestimmungsgemäßen Anwendung abziehbare Schutzfolie (18) abgedeckt ist.

7. Fxierhilfe nach Anspruch 1 oder Anspruch 3, **dadurch gekennzeichnet**, daß der/die Klebestreifen (13, 17) Löcher (25) im Rastermaß für den Eingriff von Bauteilausstoßern im Bestückautomaten aufweisen.

8. Verbindungshilfe nach Anspruch 1, **dadurch gekennzeichnet**, daß die Noppen (15) aus dem Träger (10, 20, 30) herausgeprägt sind.

9. Verbindungshilfe nach Anspruch 1, **dadurch gekennzeichnet**, daß der Träger (10, 20, 30) aus einer Folie oder aus stabilem Papier besteht.

10. Verbindungshilfe nach Anspruch 1, **dadurch gekennzeichnet**, daß der Klebestreifen eine Klebefolie (13, 17) ist, die mit der nichtklebenden Seite auf dem Träger (10, 20, 30) abziehbar befestigt ist.

11. Verbindungshilfe nach einem der vorhergehenden Ansprüche, **dadurch gekennzeichnet**, daß die Klebestreifen (13, 17) durch Ultraschallschweißen od. dgl. auf dem Träger (20) befestigt sind.

12. Verbindungshilfe nach einem der vorhergehenden Ansprüche, **dadurch gekennzeichnet**, daß die Klebestreifen (13, 17) mittels geringerer Klebehaftung als auf ihrer Oberseite auf dem Träger (10, 20, 30) befestigt sind.

13. Verbindungshilfe nach einem der vorhergehenden Ansprüche, **dadurch gekennzeichnet**, daß der Träger (10, 20, 30) mit Klebestreifen (13, 17) und ggfs. Schutzfolie (18) als Band auf einer Rolle magazinierbar ist und bedarfsweise als Streifen ablängbar ist.

14. Verbindungshilfe nach einem der vorhergehenden Ansprüche, **dadurch gekennzeichnet**, daß der Träger (10, 20, 30) mit Klebestreifen (13, 17) und ggfs. Schutzfolie (18) auf geeignete Länge konfektioniert ist.

## Claims

1. Splicing aid for connecting component belts, preferably with electronic SMDs, in order to feed the components to pick-and-place component handlers, the belts having in a lateral track guide holes with grid dimensions, characterized by a carrier (10, 20, 30) with at least two parallel tracks (11; 12, 16), one track (11) of which has knobs (15) with the same grid dimensions as the guide holes (5) of the belt (1) and the further track (12, 16) has at least one detachable adhesive strip (13, 17).

2. Connecting aid according to Claim 1, characterized in that the knobs (15) and the adhesive strip (13, 17) are located on the same surface side of the carrier (10, 20, 30).

3. Splicing aid according to Claim 2, characterized in that two tracks (12, 16) having adhesive strips (13, 17) are applied in each case in parallel on the carrier (20, 30) for arrangement on both sides of the belt (1) and a thinning in the material in the carrier (20, 30) is present between the two tracks (12, 16).

4. Splicing aid according to Claim 3, characterized in that a bending fold (19) is present in the carrier (20, 30) between the two tracks (12, 16) with adhesive strips (13, 17), it being possible simultaneously to apply the second adhesive strip (17) on the underside of the belt (1) precisely in terms of position and grid dimensions by bending over the carrier (10).

5. Connecting aid according to Claim 3 or 4, characterized in that knobs (15) are present with the grid dimensioning of the guide holes (5) of the belt (1) on both tracks (12, 12') of the carrier (30) which are adjacent on the outside to the adhesive strips (17, 18).

6. Splicing aid according to Claim 1 or Claim 3, characterized in that the outer layer of the adhesive strip(s) (13, 17) is covered by a protective film (18) which can be pulled off before application according to specification.

7. Splicing aid according to Claim 1 or Claim 3, characterized in that the adhesive strip(s) (13, 17) have holes (25) with grid dimensions for engagement of component ejectors in pick-and-place component handlers.

8. Connecting aid according to Claim 1, characterized in that the knobs (15) are stamped out of the carrier (10, 20, 30).

9. Connecting aid according to Claim 1, characterized in that the carrier (10, 20, 30) comprises a film or sturdy paper.

10. Connecting aid according to Claim 1, characterized in that the adhesive strip is an adhesive film (13, 17) which is attached in a pull-off fashion with the non-adhesive side on the carrier (10, 20, 30).

11. Connecting aid according to one of the preceding claims, characterized in that the adhesive strips (13, 17) are attached on the carrier (20) by ultrasonic welding or the like.

12. Connecting aid according to one of the preceding claims, characterized in that the adhesive strips (13, 17) are attached on the carrier (10, 20, 30) by means of less adhesion than on their upper side.

13. Connecting aid according to one of the preceding claims, characterized in that the carrier (10, 20, 30) with adhesive strips (13, 17) and, if appropriate, protective film (18) can be provided in a magazine as a belt on a roller and can be cut to size as strips as required.

14. Connecting aid according to one of the preceding claims, characterized in that the carrier (10, 20, 30) with adhesive strips (13, 17) and, if appropriate, protective film (18) is ready-made to a suitable length.

## Revendications

1. Auxiliaire de fixation pour relier des bandes-supports pour composants, notamment avec des composants électroniques CMS pour amener ces composants à des machines automatiques servant à garnir les circuits imprimés, les bandes-supports étant pourvues, dans une piste latérale, de trous de guidage à espacement déterminé, caractérisé par un support (10, 20, 30) comprenant au moins deux pistes parallèles (11; 12, 16), dont l'une (11) présente des éléments saillants (15) à espacement déterminé identique à celui des trous de guidage (5) de la bande-support (1) et l'autre (12,16) est pourvue d'au moins une bande adhésive (13, 17) amovible.

2. Auxiliaire de liaison selon la revendication 1, caractérisé en ce que les éléments saillants (15) et la bande adhésive (13, 17) se trouvent sur la même face plane du support (10, 20, 30).

3. Auxiliaire de fixation selon la revendication 2, caractérisé en ce que deux pistes (12, 16) pourvues d'une bande adhésive (13, 17) peuvent être appliquées, respectivement, de manière parallèle sur le support (20, 30) afin d'être placées sur les deux côtés de la bande-support (1), et en ce qu'il existe dans le support (20, 30) un amincissement du matériau entre les deux pistes (12, 16).

4. Auxiliaire de fixation selon la revendication 3, caractérisé en ce que le support (20, 30) comporte, entre les deux pistes (12, 16) pourvues d'une bande adhésive (13, 17), une rainure de pliage (19), la deuxième bande adhésive (17) pouvant, lorsque l'on plie le support (10), être amenée simultanément sur la face inférieure de la bande-support (1), dans une position exacte correspondant audit espacement déterminé.

5. Auxiliaire de liaison selon la revendication 3 ou 4, caractérisé en ce que les deux pistes (12, 12') du support (30) contiguës aux bandes adhésives (17, 18) du côté extérieur sont pourvues d'éléments saillants (15) à espacement déterminé identique à celui des trous de guidage (5) de la bande-support (1).

6. Auxiliaire de fixation selon la revendication 1 ou 3, caractérisé en ce que la couche externe de la/des bande/s adhésive/s (13, 17) est couverte par une feuille de protection (18) pouvant être retirée avant l'utilisation conforme aux prescriptions.

7. Auxiliaire de fixation selon la revendication 1 ou 3, caractérisé en ce que la/les bande/s adhésive/s (13, 17) est/sont pourvue/s de trous (25) à espacement déterminé pour l'engagement d'éléments pousseurs de composants dans les machines automatiques servant à garnir les circuits imprimés.

8. Auxiliaire de liaison selon la revendication 1, caractérisé en ce que les éléments saillants (15) sont estampés à partir du support (10, 20, 30).

9. Auxiliaire de liaison selon la revendication 1, caractérisé en ce que le support (10, 20, 30) est formé par une feuille ou du papier robuste.

10. Auxiliaire de liaison selon la revendication 1, caractérisé en ce que la bande adhésive est une feuille adhésive (13, 17) qui est fixée sur le support (10, 20, 30) par sa face non adhésive de manière à pouvoir être retirée.

11. Auxiliaire de liaison selon l'une des revendications précédentes, caractérisé en ce que les bandes adhésives (13, 17) sont fixées sur le support (20) par soudage par ultrasons ou un procédé semblable.

12. Auxiliaire de liaison selon l'une des revendications précédentes, caractérisé en ce que les bandes adhésives (13, 17) sont fixées sur le support (10, 20, 30) grâce à un pouvoir d'adhérence moins important que sur leur face supérieure.

13. Auxiliaire de liaison selon l'une des revendications précédentes, caractérisé en ce que le support (10, 20, 30) pourvu de bandes adhésives (13, 17) et, le cas échéant, d'une feuille de protection (18), peut être mis en magasin en tant que ruban sur un rouleau et peut, le cas échéant, être coupé à la longueur sous forme de bandes.

14. Auxiliaire de liaison selon l'une des revendications précédentes, caractérisé en ce que le support (10, 20, 30) pourvu de bandes adhésives (13, 17) et, le cas échéant, d'une feuille de protection (18), est confectionné à la longueur appropriée.
